# EUROPEAN PATENT SPECIFICATION

(11) **EP 0 534 505 B1**
(45) Date of publication and mention of the grant of the patent: **09.12.1998**
(21) Application number: 92120852.6
(22) Date of filing: 05.07.1990
(51) Int. Cl.: C23C 14/28, C23C 14/16, C23C 14/32, C23C 14/54

(54) **Laser deposition method**
Verfahren zum Laseraufdampfen
Procédé de déposition utilisant un laser

(30) Priority: 06.07.1989 JP 176388/89; 22.08.1989 JP 215420/89; 25.01.1990 JP 16796/90
(43) Date of publication of application: 31.03.1993
(62) Divisional of application: 90112878.5
(73) Proprietor: TOYOTA JIDOSHA KABUSHIKI KAISHA, Aichi-ken (JP)
(72) Inventor: Akihama, Kazuhiro, Nagoya-shi, Aichi-ken (JP); Kizaki, Yoshimi, Nagoya-shi, Aichi-ken (JP); Takayanagi, Noboru, Toyota-shi, Aichi-ken (JP)
(74) Representative: Tiedtke, Harro, Dipl.-Ing.

(56) References cited:
- US-A- 3 961 103
- CHEMICAL ABSTRACTS, vol. 110, no. 14, 3 April 1989, Columbus, Ohio, US; abstract no. 119365c, BAGMUT ET AL. 'AMORPHIZATION OF IRON AND CHROMIUM IN LASER EVAPORATION' page 294 ;
- CHEMICAL ABSTRACTS, vol. 109, no. 12, 19 September 1988, Columbus, Ohio, US; abstract no. 97298h, KADRI ET AL. 'PREPARATION AND IR PROPERTIES OF CRYSTALLINE AND AMORPHOUS TUNGSTEN AND TUNGSTEN DISILICIDE FILMS' page 259 ;
- APPLIED PHYSICS LETTERS. vol. 53, no. 3, 18 July 1988, NEW YORK US pages 187 - 188 WAGAL ET AL. 'DIAMOND-LIKE CARBON FILMS PREPARED WITH A LASER ION SOURCE'
- APPLIED PHYSICS A. SOLIDS AND SURFACES. vol. A45, no. 4, April 1988, HEIDELBERG DE pages 355 - 360 SATO ET AL. 'DIAMOND-LIKE CARBON FILMS PREPARED BY PULSED-LASER EVAPORATION'
- Thin Solid Films, vol.72 (1980), pages 19-31
- Appl.Phys.Letts, vol.29(2), 1976, pages 118-120
- J.Appl.Phys.. vol.42, 1971, pages 2953-2958

## Description

This invention relates to laser deposition technology in which laser light is irradiated to a target so that an emitting material emitted from the target is deposited on a substrate to form an amorphous metal film.

Amorphous materials are not entirely crystalline and have only short-range order in its structure, having characteristics good in corrosion resistance, wear resistance, etc.

Further, amorphous iron or iron alloy has a good magnetic characteristic, such as a high magnetic permeability and a low coercive force, so that materials suitable for use in various kinds of applied art such as transformers and magnetic heads are provided. Consequently, researches and studies have in recent years been made on amorphous materials.

Heretofore, for forming amorphous materials such as an amorphous film, a vacuum deposition method, a sputtering method and a liquid quenching method are known.

In the vacuum deposition method, a sample is heated and evaporated in a vacuum chamber by, for example, a heater, and is deposited and cooled on a substrate to form an amorphous film.

In the sputtering method, a plasma of argon or nitrogen gas is formed in a vacuum chamber to sput (strike out) sample particles with the plasma particles so that the sample particles are deposited and cooled on a substrate.

In the liquid quenching method, a sample is melted by heating at a temperature higher than its melting point, and the melted sample is then cooled quickly.

However, according to the liquid quenching method, there is a limit in the cooling rate (maximum speed of about 10⁷ K/sec), and hence only limited kinds of metals or alloys can be made amorphous.

According to the vacuum deposition method, since the energy of the sample particles during deposition is relatively low, the cooling rate of the sample particles deposited on the substrate is small so that only limited kinds of metals or alloys can be made amorphous.

According to the sputtering method, the cooling rate of the sample particles on the substrate is higher than that in the vacuum deposition method, but argon gas in the atmosphere will be mixed into a prospective film during sputtering, thus deteriorating the film quality. Therefore it is difficult to form a good quality amorphous film. Forming a single-metal or alloy amorphous film requires a high cooling rate of, for example, higher than 10¹⁰K/sec for Fe (iron) [Publication by H. A. Davies: proc. of 3rd intern. conf. on Rapidly Quenched Metals (1978) 1]. For this reason, according to the conventional methods, such good quality amorphous film could not be achieved. Moreover, Chem. Abs. 109:97298h & Materials Science and Engineering **98**(1988) 79 to 84 discloses the preparation of amorphous thin films of tungsten by reactive cathodic sputtering.

In addition, Chem. Abs. 110:119365c & Pis'ma Zh. Tekh. Fiz. **14**(23) (1988) 2187-90 discloses amorphous iron films which are formed using an iron target having a high purity without deliberately adding any impurities to promote amorphization. The resulting composition of the condensates can be described by the formula MₓO_{y}. The amorphous iron films are produced by pulsed laser sputtering of Fe targets without applying an electric field.

Moreover, Appl. Phys. Lett. **53**(3) (1988) 187-8 discloses the formation of diamond-like carbon films wherein a laser as well as an electric field is applied for depositing diamond-like carbon films. In document D3 the graphite structure is removed from an amorphous structure.

Furthermore, Appl. Phys. A 45 (1988) 355-360 discloses the formation of amorphous diamond-like carbon thin films by employing a photo-CVD technique.

It is an object of the present invention to provide a method of an amorphous metal film having a high purity which is more simple and can be used at room temperature.

According to the present invention, the above object is achieved by a method of producing an amorphous metal film comprising the steps of (a) placing a target, made of an alloy or a single metal, and a substrate in a vacuum chamber whose interior is kept in a high vacuum state, (b) irradiating laser light to a surface of said target to evaporate a high-speed evaporated material from said target, (c) applying an electric field between said target and said substrate, depending on a critical cooling rate needed for making said high-speed evaporated material on said substrate amorphous and depending on an impact energy of said high-speed evaporated material against said substrate, and (d) cooling said high-speed evaporated material on said substrate at said critical cooling rate and accelerating a charged component of said high-speed evaporated material to increase said impact energy against said substrate so that agitation occurs in the atom arrangement to form said amorphous metal film on said substrate.

Since the laser is capable of concentrating energy on the target at high density, the emitting velocity of the evaporated material is greater than in the conventional art and the temperature (energy) of the evaporated material is higher than in the conventional art. Therefore it is possible to increase the cooling rate from (the temperature of the evaporated material to room temperature) of the evaporated material on the substrate. Further, since the evaporated material can be formed in high vacuum, it is possible to prevent impurities from mixing in the film.

If the evaporated material contains positively or negatively charged particles, the application of electric field can increase the energy of the charged component of the evaporated material and increase the cooling rate of the charged component, and can break the chemical bond in the deposited film and implant the high-energy evaporated material thereinto to agitate the atom arrangement of the film, thus easily making the film structure amorphous. Accordingly, an amorphous film of a single metal or alloy requiring a high cooling rate, for example, an amorphous magnetic film such as of Fe (iron) having a good magnetic characteristic can be produced.

As discussed above, by utilizing laser light, it is possible to obtain an amorphous single-metal or alloy film.

The amorphous metal or alloy film, for example, an amorphous iron film is excellently resistant to corrosion and wear and has a good magnetic characteristic, such as high magnetic flux density, high magnetic permeability and low coercive force, so that materials suitable for use in various kinds of applied art such as transformers and magnetic heads.

The above and other advantages, features and additional objects of this invention will be manifest to those versed in the art upon making reference to the following detailed description and the accompanying drawings in which several preferred embodiments incorporating the principles of this invention are shown by way of illustrative example.

### BRIEF DESCRIPTION OF THE DRAWINGS

FIGS. 1 and 2 show an amorphous metal film producing apparatus embodying this invention;
FIG. 3, (A), (B) and (C), is pattern diagrams showing the result of X-ray diffraction of a sample amorphous pure iron film;
FIG. 4 is a characteristic diagram showing saturation magnetic flux densities of sample amorphous pure iron film and iron alloy film; and
FIG. 5 is a pattern diagram showing the result of X-ray diffraction of a sample amorphous tungsten film.

### DETAILED DESCRIPTION

The invention will now be described with reference to the accompanying drawings.

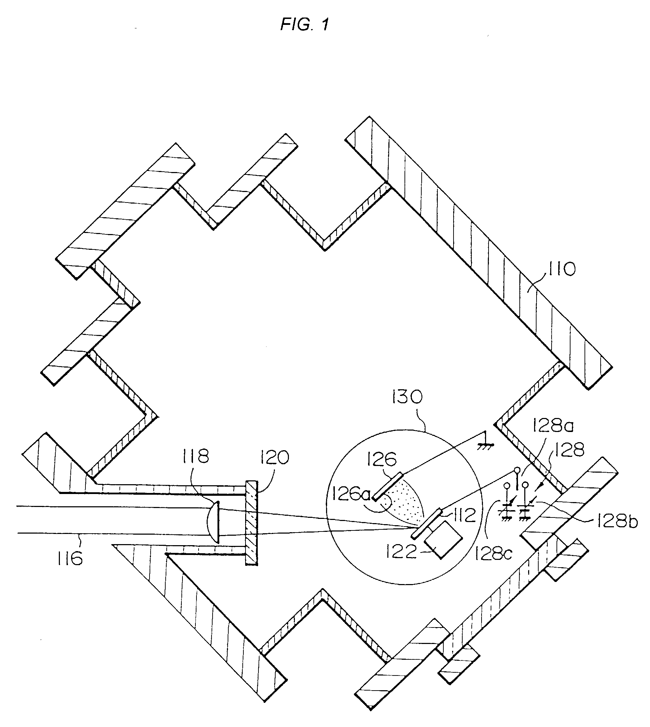

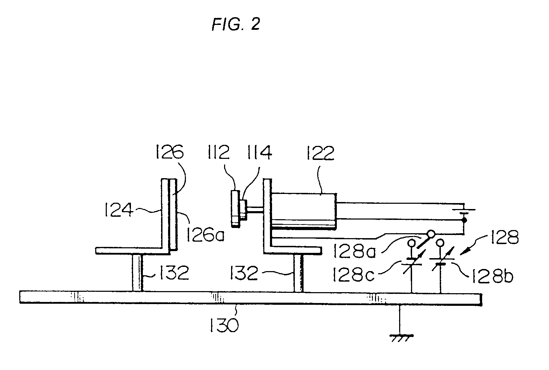

FIGS. 1 and 2 show an amorphous metal film producing apparatus for performing the method of the present invention.

As shown in FIGS. 1 and 2, a vacuum chamber 110 is vacuumed at its interior by a non-illustrated pump. Inside the vacuum chamber 110, a target 112 for material of an amorphous film is mounted on a target holder 114, and laser light 116 from a non-illustrated laser light generator means is irradiated to the target 112 via a condenser lens 118 and a transmitting window 120. The target 112 is rotated at a constant speed by a d.c. motor 122 so that the target 112 is prevented from point damage due to focus of the laser light 116.

A substrate holder 124 is disposed in confronting relation to the target 112 with a predetermined distance therebetween. A substrate 126, on which particles evaporated from the target 112 are deposited to form a film 126a as described below, is mounted on the substrate holder 124. In the illustrated embodiment, glass is used for the substrate 126.

The substrate holder 124 is connected to the ground and the target holder 114 is connected to a d.c. power supply 128, giving a desired potential difference between the target 112 and the substrate 126. The d.c. power supply 128 is composed of a switch 128a, a positive variable power supply 128b and a negative variable power supply 128c, keeping the target 112 at a desired potential.

This application of potential is performed on a single metal or alloy, such as of Fe or Ni, which requires a high cooling rate. The application of potential can increase the energy of the charged component in the evaporated material to increase the cooling rate of the evaporated material, can break the chemical bond in the deposited film 126a, can implant the high-energy evaporated material into the film to agitate the atom arrangement of the film 126a, thus making the film structure amorphous. At that time, if a positive potential is applied, the negatively charged particles in the emitted material will be repelled, and the negatively charged particles will be accelerated. Reversely, if a negative potential is applied, the positively charged particles of the emitted material will be accelerated, and the positively charged particles will be repelled.

Therefore, by applying the positive or negative potential, it is possible to increase the energy of the evaporated material, increase the cooling rate, breaking the chemical bond in the deposited film 126a and implant the high-energy evaporated material into the film 126a, thus making the film structure amorphous.

The substrate holder 124 and the target holder 114 are supported on a positioning rotary stage 130 via an insulator 132.

### Experiment 1

To form an amorphous pure iron film, pure iron was mounted on the target holder 114, and then the interior of the vacuum chamber 110 was vacuumed at lower than 1,33·10⁻³Pa (1x10⁻⁵Torr).

Then, using KrF excimer laser, which can produce a high output (wavelength of 249 nm, pulse width of 16 nsec, pulse frequency of 25 pulses/sec and pulse energy of 250 mJ), laser light 116 was irradiated to the target 112 of pure iron (99.999% purity) for 20 minutes while the target 112 was rotating at 20 rpm. The angle of irradiation of laser light with respect to the normal of the surface of the target holder 114 was about 45°, and the area of the laser light 116 irradiated on the pure-iron target 112 was about 6x10⁻³cm².

Subsequently, a predetermined potential is applied to the target holder 114 by the d.c. power supply 128. As a result, an amorphous pure-iron film 126a was formed on the glass substrate 126.

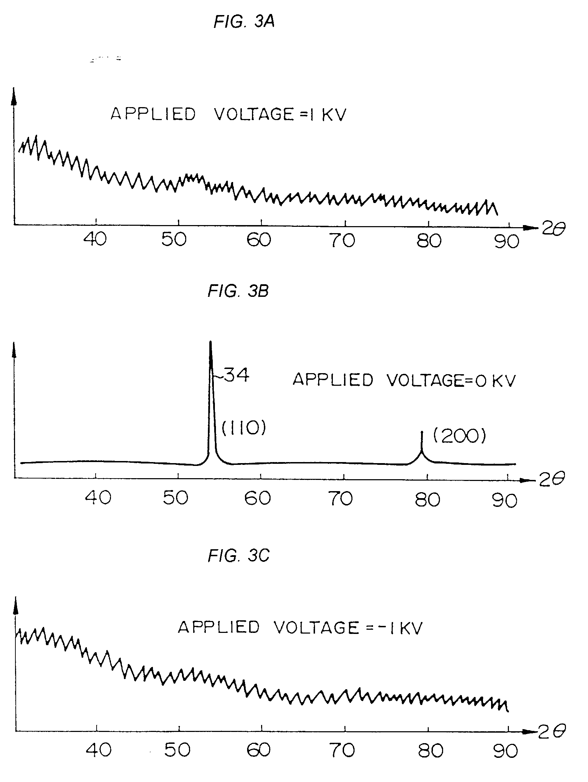

FIG. 3, (A), (B) and (C), shows the results of X-ray diffraction of the amorphous pure-iron film 126a when the applied voltage was 1 kV, 0 kV and -1 kV.

In FIG. 3, the horizontal coordinate represents the diffraction angle, and the vertical coordinate represents the diffraction intensity of X-ray. The X-ray diffraction pattern of the applied voltage 0 kV shows a crystal structure having a peak 34 on the (110) plane. However, with the films 126a when the applied voltage was 1 kV and -1 kV, their X-ray diffraction patterns were broad patterns each not having remarkable peaks, showing a noncrystalline structure.

Thus, because the high-energy evaporated material is forced into the film by application of electric field, it is possible to form an amorphous pure-iron film.

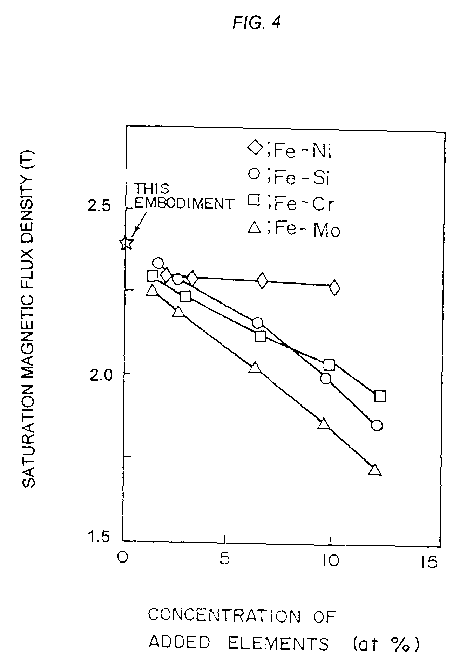

FIG. 4 shows the change of saturation magnetic flux densities when other metal elements were individually added to pure iron. According to the amorphous pure-iron film of this example, the saturated magnetic flux density was 2,4T (24 kG), which was relatively large, compared to that with the case where another element such as Ni, Si, Cr or Mo was added to pure iron.

Accordingly, with the amorphous pure-iron film of this embodiment, it is possible to realize a high magnetic flux density, compared to the conventional alloy film. This amorphous pure-iron film is particularly suitable for various kinds of parts or devices such as transformers and magnetic heads.

### Experiment 2

To form an amorphous tungsten (hereinafter called "W") film, pure W was mounted on the target holder 114, and then the interior of the vacuum chamber 110 was vacuumed at lower than 1,33^{.}10⁻³Pa (1x10⁻⁵Torr).

Then, using KrF excimer laser, which can produce a high output (wavelength of 249 nm, pulse width of 16 nsec, pulse frequency of 25 pulses/sec and pulse energy of 250 mJ), laser light 116 was irradiated to the target 112 of pure iron (99.999% purity) for 20 minutes while the target 112 was rotating at 20 rpm. The angle of irradiation of laser light with respect to the normal of the surface of the target holder 114 was about 45°, and the area of the laser light 116 irradiated on the pure-W target 112 was about 6x10⁻³cm².

Subsequently, a predetermined potential is applied to the target holder 114 by the d.c. power supply 128. As a result, an amorphous pure-W film 126a was formed on the glass substrate 126.

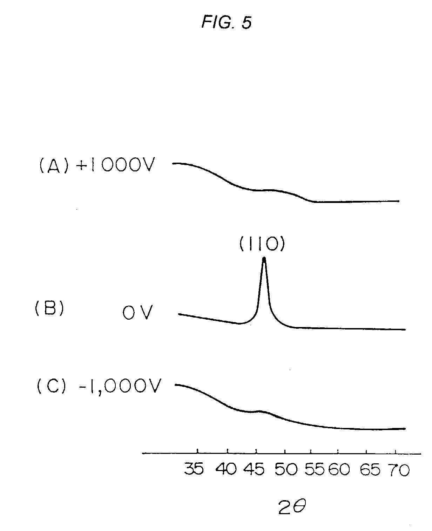

FIG. 5 (A), (B) and (C), shows the results of X-ray diffraction of the amorphous pure-W film 126a when the applied voltage was 1 kV, 0 kV and -1 kV.

In FIG. 5, the horizontal coordinate represents the diffraction angle, and the vertical coordinate represents the diffraction intensity of X-ray. The X-ray diffraction pattern of the applied voltage 0 kV shows a crystal structure having a peak 34 on the (110) plane. However, with the films 126a when the applied voltage was 1 kV and -1 kV, their X-ray diffraction patterns were broad patterns each not having remarkable peaks, showing a noncrystalline structure.

Thus, because the high-energy evaporated material is forced into the film by application of electric field, it is possible to form an amorphous pure-W film.

According to this invention, it is possible to form an amorphous film of pure iron and pure W as well as another metal or alloy having a critical cooling rate lower than that of pure iron.

## Claims

1. A method of producing an amorphous metal film (126a) comprising the steps of:
(a) placing a target (112), made of an alloy or a single metal, and a substrate (126) in a vacuum chamber (110) whose interior is kept in a high vacuum state;
(b) irradiating laser light (116) to a surface of said target (112) to evaporate a high-speed evaporated material from said target (112);
(c) applying an electric field between said target (112) and said substrate (126), depending on a critical cooling rate needed for making said high-speed evaporated material on said substrate (126) amorphous and depending on an impact energy of said high-speed evaporated material against said substrate (126); and
(d) cooling said high-speed evaporated material on said substrate (126) at said critical cooling rate and accelerating a charged component of said high-speed evaporated material to increase said impact energy against said substrate (126) so that agitation occurs in the atom arrangement to form said amorphous metal film (126a) on said substrate (126).

2. A method according to claim 1, **characterized in that** iron is used for said target (112).

3. A method according to claim 2, **characterized in that** pure iron having a purity of at least 99.999 % is used for said target (112).

4. A method according to claim 1, **characterized in that** the interior of said vacuum chamber (110) is kept at less than 1.33 x 10⁻³ Pa (1 x 10⁻⁵ Torr).

5. A method according to claim 1, **characterized in that** a voltage to be applied is higher than 1 kV.

6. A method according to claim 1, **characterized in that** a voltage to be applied is lower than -1 kV.

## Patentansprüche

1. Verfahren zur Herstellung einer amorphen Metallschicht (126a), welches die Schritte aufweist,
a) Plazieren eines Targets (112), das aus einer Legierung oder einem einzelnen Metall gefertigt ist, und eines Substrats (126) in einer Vakuumkammer (110), deren Inneres in einem Hochvakuumzustand gehalten wird,
b) Abstrahlen von Laserlicht (116) auf eine Oberfläche des Targets (112), um ein abgedampftes Hochgeschwindigkeits-Material von dem Target (112) abzudampfen,
c) Anlegen eines elektrischen Felds zwischen dem Target (112) und dem Substrat (126) in Abhängigkeit von einer kritischen Abkühlgeschwindigkeit, die nötig ist, um das abgedampfte Hochgeschwindigkeits-Material auf dem Substrat (126) amorph zu machen, und in Abhängigkeit von einer Aufprallenergie des abgedampften Hochgeschwindigkeits-Materials gegen das Substrat (126), und
d) Abkühlen des abgedampften Hochgeschwindigkeits-Materials auf dem Substrat (126) mit der kritischen Abkühlgeschwindigkeit und Beschleunigung eines geladenen Bestandteils des abgedampften Hochgeschwindigkeits-Materials, um die Aufprallenergie auf das Substrat (126) zu erhöhen, so daß in der Ordnung des Atoms eine Bewegung derart auftritt, daß die amorphe Metallschicht (126a) auf dem Substrat (126) ausgebildet wird.

2. Verfahren gemäß Anspruch 1, **dadurch gekennzeichnet, daß** Eisen als das Target (112) verwendet wird.

3. Verfahren gemäß Anspruch 2, **dadurch gekennzeichnet, daß** reines Eisen, das eine Reinheit von mindestens 99,999 % hat, als das Target (112) verwendet wird.

4. Verfahren gemäß Anspruch 1, **dadurch gekennzeichnet, daß** das Innere der Vakuumkammer (110) bei weniger als 1,33 × 10⁻³ Pa (1 × 10⁻⁵ Torr) gehalten wird.

5. Verfahren gemäß Anspruch 1, **dadurch gekennzeichnet, daß** eine anzulegende Spannung höher als 1 kV ist.

6. Verfahren gemäß Anspruch 1, **dadurch gekennzeichnet, daß** eine anzulegende Spannung niedriger als -1 kV ist.

## Revendications

1. Une méthode de fabrication d'un film de métal amorphe (126a) comprenant les étapes de :
(a) mise en place d'une cible (112), fabriquée en un alliage ou en un métal simple, et un substrat (126) dans une chambre à vide (110) dont l'intérieur est maintenu sous vide poussé ;
(b) irradiation par une lumière laser (116) d'une surface de ladite cible (112) pour évaporer le matériau évaporé à grande vitesse de ladite cible (112) ;
(c) application d'un champ électrique entre ladite cible (112) et ledit substrat (126), fonction de la vitesse de refroidissement critique nécessaire pour rendre amorphe ledit matériau évaporé à grande vitesse sur ledit substrat (126) et fonction de l'énergie d'impact dudit matériau évaporé à grande vitesse contre ledit substrat (126) ; et
(d) refroidissement dudit matériau évaporé à grande vitesse sur ledit substrat (126) à ladite vitesse de refroidissement critique et accélération du composant chargé dudit matériau évaporé à grande vitesse pour augmenter ladite énergie d'impact contre ledit substrat (126) de façon à provoquer une agitation de l'ordonnance des atomes pour former ledit film métallique amorphe (126a) sur ledit substrat (126).

2. Une méthode selon la revendication 1, caractérisée en ce que l'on utilise du fer pour ladite cible (112).

3. Une méthode selon la revendication 2, caractérisée en ce que l'on utilise du fer pur ayant une pureté d'au moins 99,999 % pour ladite cible (112).

4. Une méthode selon la revendication 1, caractérisée en ce que l'intérieur de ladite chambre à vide (110) est maintenu à une pression inférieure à 1,33 x 10⁻³ Pa (1 x 10⁻⁵ Torr).

5. Une methode selon la revendication 1, caractérisée en ce que le voltage appliqué est supérieur à 1 kV.

6. Une méthode selon la revendication 1, caractérisée en ce que le voltage appliqué est inférieur à -1 kV.
